Europäisches Patentamt

European Patent Office

Office européen des brevets

(19)

(11) **EP 0 807 827 A2**

(12) **EUROPÄISCHE PATENTANMELDUNG**

(43) Veröffentlichungstag:
19.11.1997 Patentblatt 1997/47

(51) Int. Cl.⁶: **G01R 33/09**

(21) Anmeldenummer: 97107308.5

(22) Anmeldetag: 02.05.1997

(84) Benannte Vertragsstaaten:
**AT BE CH DE DK ES FR GB IT LI**

(30) Priorität: 15.05.1996 DE 19619806

(71) Anmelder:
**SIEMENS AKTIENGESELLSCHAFT**
**80333 München (DE)**

(72) Erfinder: **Clemens, Wolfgang, Dr.**
**90617 Puschendorf (DE)**

(54) **Magnetfeldempfindliche Sensoreinrichtung mit mehreren GMR-Sensorelementen**

(57) Die Sensoreinrichtung enthält zwei Stromzweige (Z1, Z2') mit GMR-Sensorelementen (S1, S2, S3', S4'), deren Dünnschichtaufbau jeweils einen Biasschichtteil besitzt. Von den Sensorelementen soll erfindungsgemäß wenigstens ein Paar (S1, S2) Magnetisierungen ($m_1$, $m_2$) ihrer Biasschichtteile aufweisen, die zumindest im wesentlichen antiparallel zueinander ausgerichtet sind und eine Bezugsrichtung (b) festlegen. Mindestens ein weiteres Sensorelement (S3', S4') soll eine Magnetisierung ($m_3$' bzw. $m_4$') seines Biasschichtteils aufweisen, die mit der Bezugsrichtung (b) einen vorbestimmten Winkel (β) einschließt. Dieser Winkel liegt vorzugsweise zwischen 20 und 160 Grad, beispielsweise bei etwa 45 oder 90 Grad.

FIG 8

EP 0 807 827 A2

## Beschreibung

Die Erfindung bezieht sich auf eine Sensoreinrichtung zur Erfassung eines äußeren Magnetfeldes mit mehreren magnetoresistiven Sensorelementen, die jeweils einen Dünnschichtaufbau aufweisen, der eine weichmagnetische Meßschicht und einen magnetisch härteren Biasschichtteil mit einer vorbestimmten Magnetisierungsrichtung enthält und einen großen magnetoresistiven Effekt (GMR) zeigt. Eine derartige Sensoreinrichtung ist der DE 44 27 495 A zu entnehmen.

In Schichten aus ferromagnetischen Übergangsmetallen wie Ni, Fe oder Co und deren Legierungen kann eine Abhängigkeit des elektrischen Widerstandes von der Größe und der Richtung eines das Material durchdringenden Magnetfeldes gegeben sein. Den bei solchen Schichten auftretenden Effekt nennt man anisotropen Magnetowiderstand „AMR" oder anisotropen magnetoresistiven Effekt. Er beruht physikalisch auf den unterschiedlichen Streuquerschnitten von Elektronen mit unterschiedlichem Spin und der Spinpolarität des D-Bandes. Die Elektronen werden deshalb Majoritäts- bzw. Minoritätselektronen bezeichnet. Für entsprechende magnetoresistive Sensoren wird im allgemeinen eine dünne Schicht aus einem solchen magnetoresistiven Material mit einer Magnetisierung in der Schichtebene vorgesehen. Die Widerstandsänderung bei Drehung der Magnetisierung bezuglich der Stromrichtung kann dann einige Prozent des normalen isotropen (= ohmschen) Widerstandes betragen.

Ferner sind seit einiger Zeit magnetoresistive Schichtensysteme bekannt, welche mehrere, zu einem Stapel angeordnete ferromagnetische Schichten enthalten, die jeweils durch nicht-magnetische Zwischenschichten voneinander getrennt sind und deren Magnetisierungen jeweils vorzugsweise in der Schichtebene liegen. Die Dicken der einzelnen Schichten sind dabei deutlich geringer als die mittlere freie Weglänge der Leitungselektronen gewählt. In derartigen Mehrschichtensystemen kann nun zusätzlich zu dem erwähnten anisotropen magnetoresistiven Effekt AMR ein sogenannter giant-magnetoresistiver Effekt oder Giant-Magnetowiderstand (GMR) auftreten (vgl. z.B. EP 0 483 373 A). Ein solcher GMR-Effekt beruht auf der unterschiedlich starken Streuung von Majoritäts- und Minoritäts-Leitungselektronen an den Grenzflächen zwischen den ferromagnetischen Schichten und den dazu benachbarten Zwischenschichten sowie auf Streueffekten innerhalb dieser Schichten. Der GMR-Effekt ist dabei ein isotroper Effekt. Er kann erheblich größer sein als der anisotrope Effekt AMR und Werte bis zu mindestens 70 % des normalen isotropen Widerstandes annehmen. Bei einem ersten Typ von entsprechenden, einen GMR-Effekt zeigenden Mehrschichtensystemen sind benachbarte magnetische Schichten ohne ein äußeres Magnetfeld aufgrund einer gegenseitigen Kopplung magnetisch antiparallel ausgerichtet. Diese Ausrichtung kann dann durch ein äußeres Magnetfeld in eine parallele Ausrichtung überführt werden. Demgegenüber weist ein zweiter Typ von GMR-Mehrschichtensystemen eine Biasschicht bzw. einen Biasschichtteil auf, der magnetisch härter ist als eine (magnetisch weichere) Meßschicht. Diese beiden Schichten sind durch eine nicht magnetische Zwischenschicht gegenseitig magnetisch entkoppelt. Ohne ein äußeres Magnetfeld stehen dann die Magnetisierungen der beiden magnetischen Schichten irgendwie zueinander, beispielsweise antiparallel. Unter dem Einfluß eines äußeren Magnetfeldes wird dann die Magnetisierung der weichmagnetischen Meßschicht entsprechend der Feldrichtung ausgerichtet, während die Ausrichtung der magnetisch härteren Biasschicht unverändert bleibt. Dabei bestimmt der Winkel zwischen den Magnetisierungsrichtungen der beiden magnetischen Schichten den Widerstand des Mehrschichtensystems: Bei einer parallelen Ausrichtung ist der Widerstand klein und bei einer antiparallelen groß. Bei entsprechenden Magnetfeldsensoren wird diese Tatsache ausgenutzt.

Eine Sensoreinrichtung mit vier zu einer Brückenschaltung verschalteten entsprechenden Magnetfeldsensorelementen geht aus der eingangs genannten DE-A-Schrift hervor. Dabei weisen in jedem Brückenzweig die beiden Sensorelemente Magnetisierungen ihrer Biasschichtteile auf, die zumindest im wesentlichen zueinander antiparallel gerichtet sind. Die Sensorelemente sind somit vom vorerwähnten zweiten Typ.

Bei solchen Mehrschichtsystemen mit GMR-Sensorelementen vom zweiten Typ kann der elektrische Widerstand in zwei Anteile zerlegt werden, nämlich in einen feldempfindlichen Anteil $\Delta R$ und einen davon unabhängigen Grundwiderstand $R_0$. Dabei beträgt in empfindlichen Systemen der feldempfindliche Anteil $\Delta R$ typischerweise 5 bis 30 % vom Grundwiderstand $R_0$. Bei der elektronischen Auswertung des Sensorsignals wirkt sich der Grundwiderstand $R_0$ als störende Offset-Spannung aus. Es zeigt sich zudem, daß insbesondere der Grundwiderstand $R_0$ eine Abhängigkeit von der Betriebstemperatur T besitzt. So ist z.B. bei Raumtemperatur $T_a$ der Grundwiderstand $R_0$, der von einem stark temperaturabhängigen Beitrag der Phononen geprägt ist, annähernd proportional zu $T/T_a$ und beträgt beispielsweise etwa 0,1 % pro Kelvin. Eine derartige Änderung ist für die meisten Anwendungen unerwünscht. Aus diesem Grunde hat man einzelne magnetoresistive Sensoren mit einem zusätzlichen Temperatursensor versehen oder ist zum Aufbau einer Brückenschaltung mit vier Sensoren übergegangen.

Mit der bekannten Brückenschaltung von vier GMR-Sensorelementen, deren Magnetschichtensysteme vom zweiten Typ mit jeweils einem magnetisch härteren Biasschichtteil und einer magnetisch weicheren Meßschicht sind, läßt sich nur ein Winkelbereich bezüglich einer Komponente eines äußeren Magnetfeldes erfassen, der 180° beträgt. Fur den vollen Winkelbereich von 360° ist es folglich erforderlich, eine weitere Sensoreinrichtung mit einer Brückenschaltung vorzusehen, wobei die Bezugsachsen der beiden Brücken senkrecht aufeinanderstehen. D.h., für die Wickelinformation sind zwei Sensoreinrichtungen mit zueinander senkrechter Ausrichtung ihrer Magnetisierungen und für eine Offset-Spannungskompensation Sensoreinrichtungen mit Brückenschaltungen erforderlich. Das bedeutet aber, daß insgesamt acht Sensorelemente benötigt werden, die eine entsprechend große Fläche einnehmen und gegeneinander abgeglichen werden müssen.

Aufgabe der vorliegenden Erfindung ist es, die Sensoreinrichtung mit den eingangs genannten Merkmalen dahingehend auszugestalten, daß mit wenigen Sensorelementen Aussagen bezüglich der Richtung und/oder Stärke eines äußeren Magnetfeldes ermöglicht werden, wobei auch der Einfluß der Temperaturabhängigkeit der Gesamtheit der Elemente zu unterdrücken ist.

Diese Aufgabe wird erfindungsgemäß dadurch gelöst, daß mindestens ein Paar von Sensorelementen vorgesehen ist, deren Magnetisierungen ihrer Biasschichtteile zumindest im wesentlichen zueinander antiparallel ausgerichtet sind und eine Bezugslinie festlegen und daß mindestens ein weiteres Sensorelement vorgesehen ist, dessen Magnetisierung seines Biasschichtteils mit der Bezugslinie einen vorbestimmten Winkel einschließt.

Die mit dieser Ausgestaltung der Sensoreinrichtung verbundenen Vorteile sind insbesondere darin zu sehen, daß die beiden Anteile des elektrischen Widerstandes und somit die Feld- und die Temperaturabhängigkeit getrennt elektronisch auszuwerten sind, wobei eine Offset-Spannung nicht mehr gegeben ist. Die Erfindung geht nämlich von der Erkenntnis aus, daß die mindestens zwei Sensorelemente mit der antiparallelen, eine Bezugsrichtung festlegenden Ausrichtung der Magnetisierung ihrer Biasschichtteile zur Erzeugung eines praktisch rein temperaturabhängigen Signals herangezogen werden können. Dabei wird der erste Stromzweig sowohl für eine Temperaturkompensation benötigt als auch für eine Richtungsbestimmung bis 180°. Demgegenüber dient der weitere Stromzweig dazu, den zu erfassenden Winkelbereich bis zu 360° zu erhöhen und/oder genauer zu erfassen. Dabei sind die Abmessungen der Sensoreinrichtung wegen der minimalen Anzahl von Sensorelementen entsprechend klein zu halten. Derartige Sensoreinrichtungen sind deshalb auch entsprechend kostengünstig zu erstellen.

Vorteilhafte Ausgestaltungen der Sensoreinrichtung nach der Erfindung gehen aus den abhängigen Ansprüchen hervor.

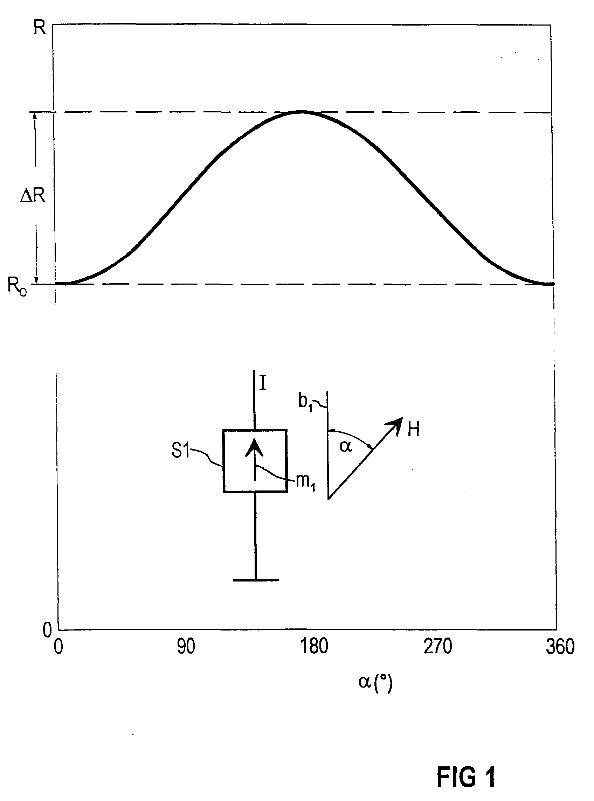

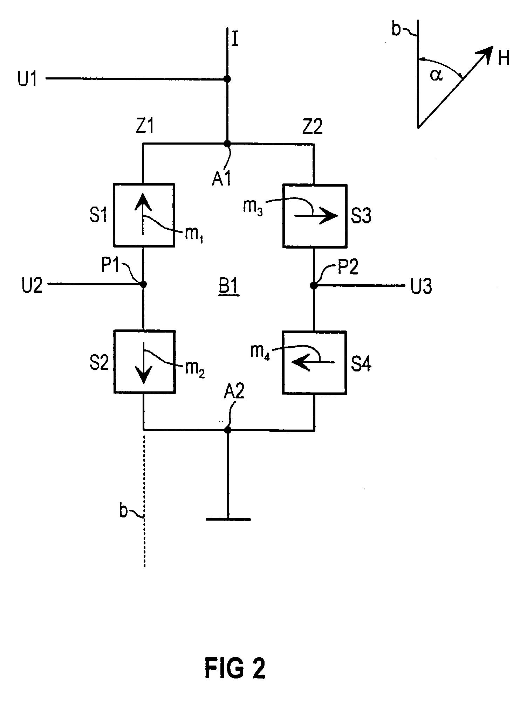

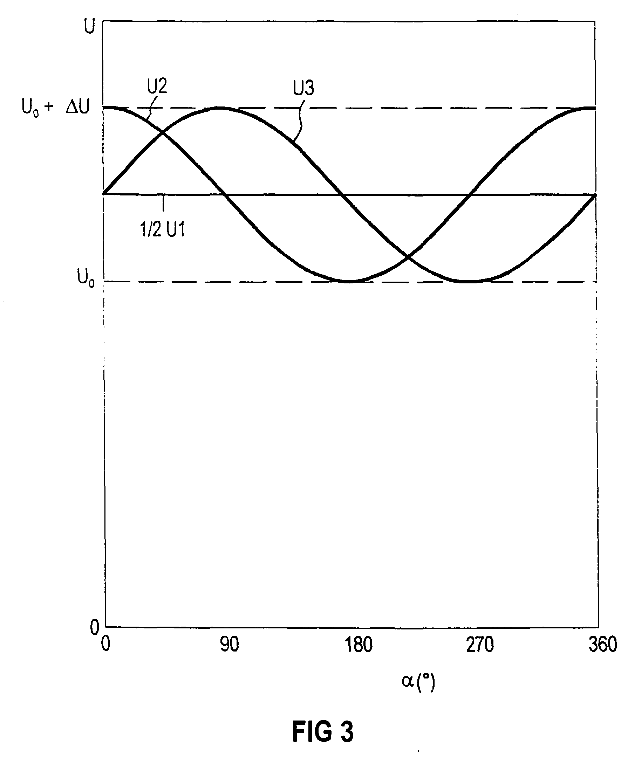

Die Erfindung wird nachfolgend unter Bezugnahme auf die Zeichnung noch weiter erläutert. Dabei zeigen in der Zeichnung jeweils schematisch

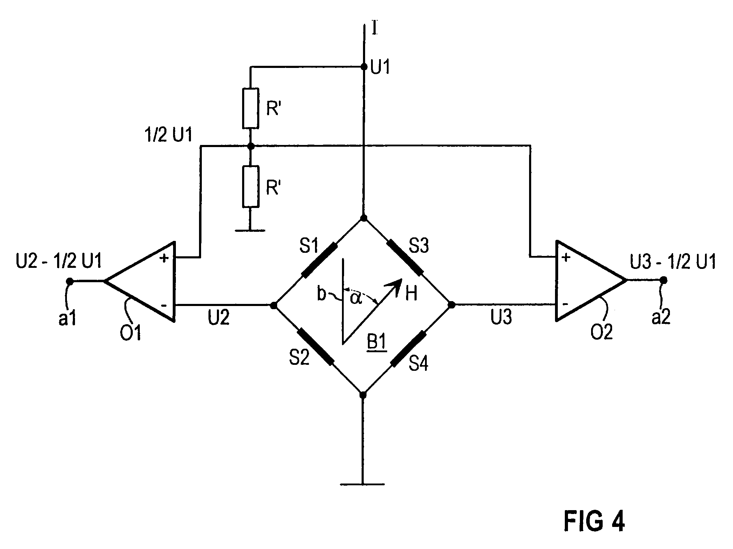

deren Figur 1    die Widerstandscharakteristik eines bekannten Sensorelementes mit GMR-Effekt,

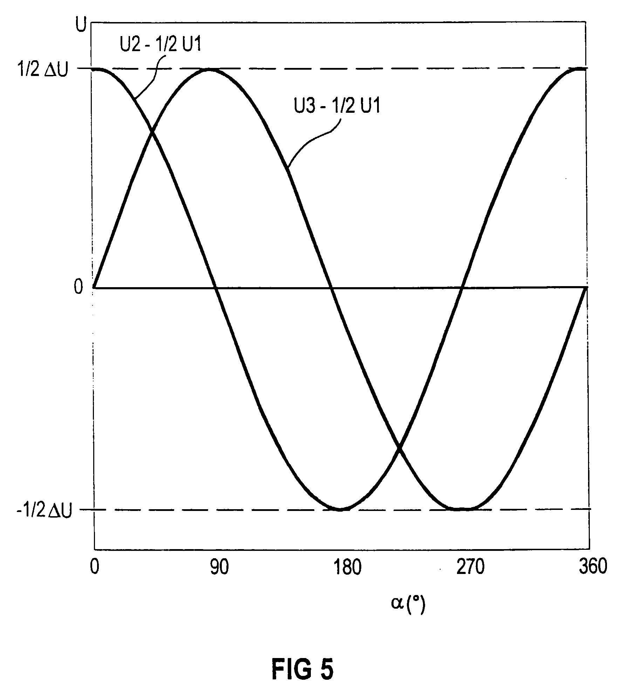

deren Figur 2    eine erfindungsgemäße Sensoreinrichtung mit einer Brückenschaltung aus vier Sensorelementen mit GMR-Effekt,

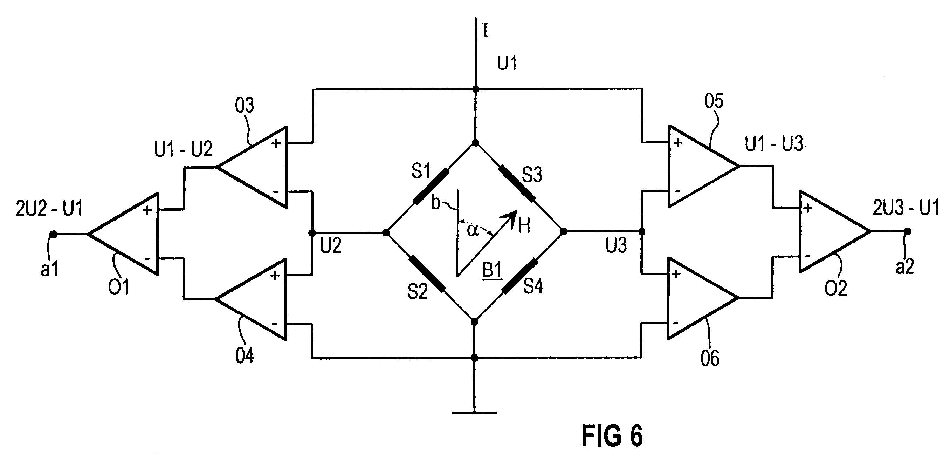

deren Figur 3    die Spannungen an der Brückenschaltung gemäß Figur 2 bei konstanter Temperatur,

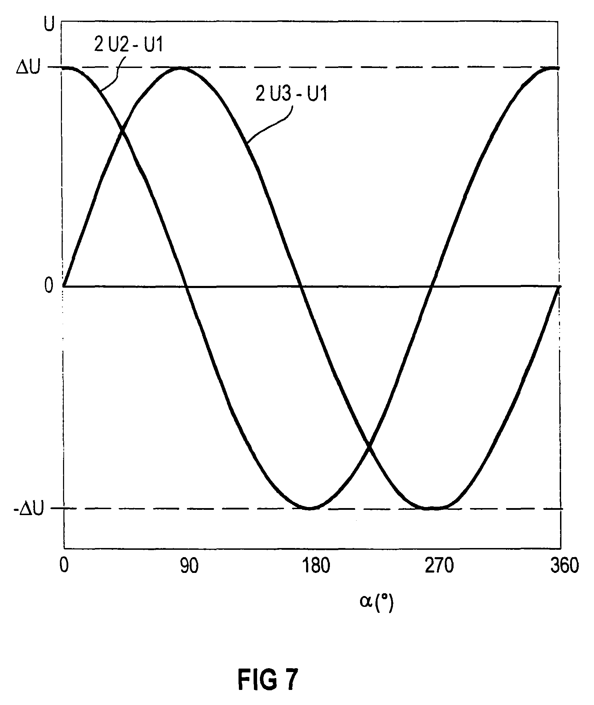

deren Figur 4    ein Blockschaltbild zur Signalauswertung der Brückenschaltung gemäß Figur 2,

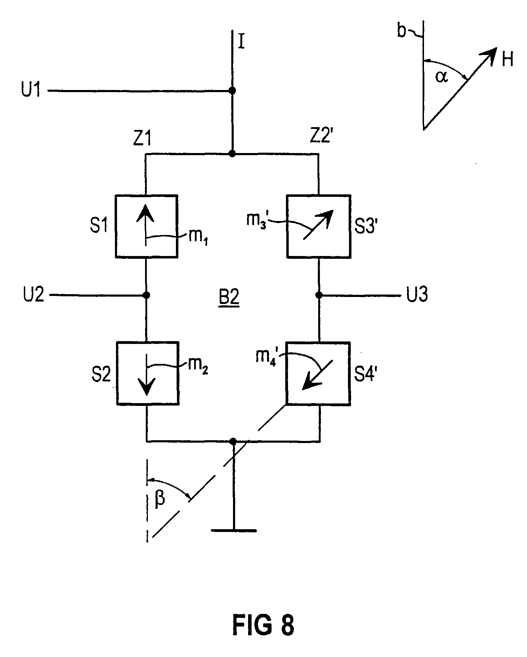

deren Figur 5    die Differenz der Spannungen an der Brückenschaltung gemäß Figur 2 mit einer Signalauswertung gemäß Figur 4,

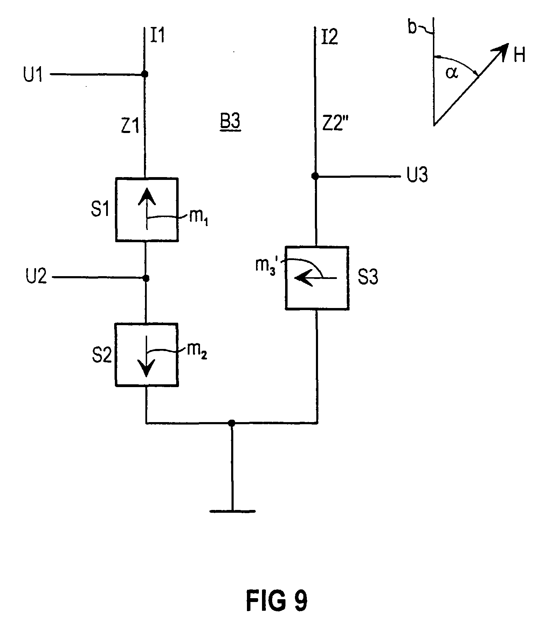

deren Figur 6    ein weiteres Blockschaltbild zur Signalauswertung der Brückenschaltung gemäß Figur 2,

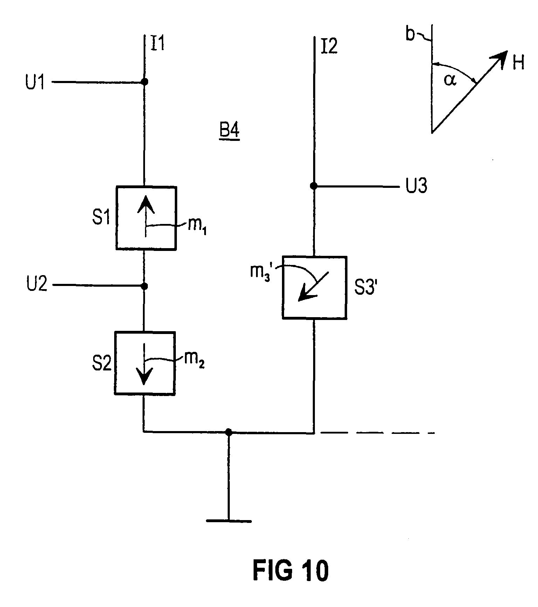

deren Figur 7    die Differenz der Spannungen an der Brückenschaltung gemäß Figur 2 mit der Signalauswertung gemäß Figur 6,

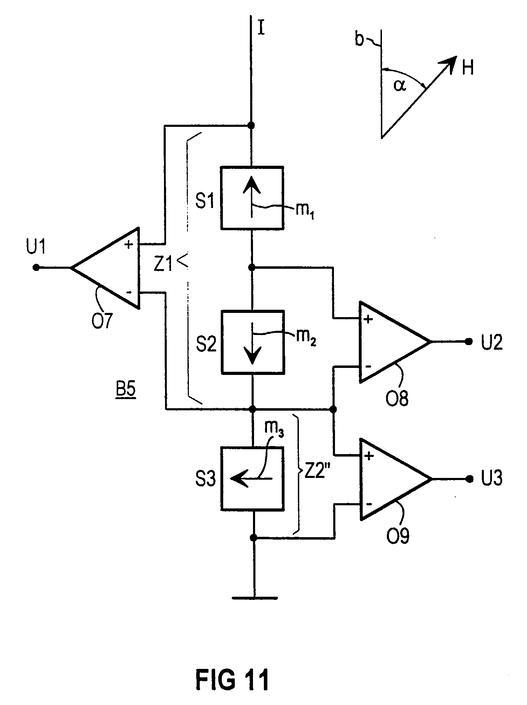

deren Figur 8    eine weitere Sensoreinrichtung mit einer Brückenschaltung von vier Sensorelementen,

deren Figur 9    eine dritte Sensoreinrichtung mit zwei insgesamt drei Sensorelemente aufweisenden Stromzweigen,

deren Figur 10   eine vierte Sensoreinrichtung ebenfalls mit drei Sensorelementen in zwei Stromzweigen sowie

deren Figur 11   eine fünfte Sensoreinrichtung, die auch drei Sensorelemente in zwei Stromzweigen aufweist.

Dabei sind in den Figuren sich entsprechende Teile mit denselben Bezugszeichen versehen.

Bei den für erfindungsgemäße Sensoreinrichtungen geeigneten Sensorelementen wird von bekannten, in Dünnfilmtechnik zu erstellenden Ausführungsformen von magnetoresistiven Elementen mit Mehrschichtsystemen, die einen sehr großen magnetoresistiven Effekt GMR zeigen, ausgegangen. Derartige Mehrschichtensysteme sind an sich bekannt (vgl. z.B. die EP 0 483 373 A oder die DE-A-Schriften 42 32 244, 42 43 357 oder 42 43 358). Ihr magnetoresistiver Effekt $M_r$ soll mindestens 2 % betragen. Dabei gilt definitionsgemäß:

$$M_r = [R\,(\uparrow\downarrow) - R(\uparrow\uparrow)]/R(\uparrow\uparrow).$$

Wegen der Feldrichtungsempfindlichkeit der Sensorelemente stellt der magnetoresistive Effekt $M_r$ den Unterschied des Widerstandes zwischen der antiparallelen und der parallelen Ausrichtung der Meßschicht bezüglich der Biasschicht bzw. eines entsprechenden Biasschichtteils dar. Dabei geht man davon aus, daß sich die magnetisch weichere Meßschicht nach der Richtung des äußeren Magnetfeldes ausrichtet, während die harte Biasschicht die Magnetisierungsrichtung beibehält. In der vorstehenden Formel ist die gegenseitige Ausrichtung der Magnetisierungen der Meßschicht und der Biasschicht durch die Lage der Pfeile veranschaulicht.

Ein entsprechendes Sensorelement enthält ein auf einem Substrat aufgebrachtes, für ein GMR-Element typisches Dünnschichtpaket. Dieses Dünnschichtpaket weist unter anderem einen magnetischen Biasschichtteil auf, der eine oder mehrere Schichten umfaßt. Mit diesem Biasschichtteil ist eine feste Magnetisierungsrichtung als eine Bezugsrichtung des Sensorelementes vorgegeben. In Figur 1 ist diese Magnetisierungsrichtung an einem Sensorelement S1 durch eine gepfeilte, mit $m_1$ bezeichnete Linie veranschaulicht. Diese Linie soll für das gezeigte Sensorelement eine Bezugsrichtung oder -linie $b_1$ darstellen.

Ferner enthalten entsprechende Sensorelemente eine weichmagnetische Meßschicht, deren Magnetisierungsrichtung sich nach einem extern angelegten Magnetfeld ausrichtet. Der Widerstand des Sensorelementes hängt nun von der relativen Orientierung der Magnetisierung der Meßschicht gegenüber der des Biasschichtteils ab. Man kann diese Widerstandsänderung ausnutzen, um die Richtung eines angelegten Magnetfeldes und so z.B. Drehpositionen oder absolute Positionen zu bestimmen (vgl. auch WO 94/17426).

Der Widerstand R eines solchen Sensorelementes setzt sich im wesentlichen aus einem Grundwiderstand $R_0$ und einem feldempfindlichen Widerstand $\Delta R$ zusammen. Dabei ist der Grundwiderstand im wesentlichen nur abhängig von der Temperatur T, während der magnetfeldempfindliche Anteil sowohl von der Temperatur T wie auch von einem Winkel $\alpha$ abhängt, den ein externes Magnetfeld H innerhalb eines vorbestimmten Feldstärkebereiches mit der Bezugsrichtung $b_1$ des Sensorelementes einnimmt (vgl. Figur 1). D.h., es gilt:

$$R(\alpha, T) = R_0(T) + \Delta R(\alpha, T) \qquad (1)$$

Die Winkelabhängigkeit des feldempfindlichen Anteils kann im wesentlichen durch eine cosinusartige Abhängigkeit vom Winkel $\alpha$ beschrieben werden. Figur 1 zeigt in einem Diagramm eine entsprechende Kurve:

$$R(\alpha, T) = R_0(T) + \tfrac{1}{2} \Delta R(T) [1 - \cos \alpha] \qquad (2)$$

Dabei sind in dem Diagramm in Ordinatenrichtung der Widerstand R (in willkürlichen Einheiten) und in Abszissenrichtung der Winkel $\alpha$ (in Grad) aufgetragen. Bei dem Wert $R = R_0$ sind die Magnetisierungsrichtungen von Biasschichtteil und Meßschicht parallel ausgerichtet, während die Magnetisierungsrichtungen bei $R = R_0 + \Delta R$ antiparallel verlaufen.

Bei einem von einem Strom I durchflossenen Sensorelement kann man nun die entsprechenden Spannungen U messen:

$$\begin{aligned} U(\alpha, T) &= R(\alpha, T)/I \qquad (3) \\ &= U_0(T) + \Delta U(\alpha, T) \\ &= U_0(T) + \tfrac{1}{2} \Delta U(T) [1 - \cos\alpha] \end{aligned}$$

Eine erfindungsgemäße Sensoreinrichtung umfaßt mindestens drei entsprechende Sensorelemente, die alle möglichst weitgehen denselben Grundwiderstand $R_0(T)$ und feldempfindlichen Widerstand $\Delta R(\alpha, T)$ haben. Alle Elemente können deshalb insbesondere gleichen Aufbau und gleiche Geometrie besitzen. Vorteilhaft kann, wie dem Ausführungsbeispiel der Figur 2 zugrundegelegt ist, eine an sich bekannte Brückenanordnung (-schaltung) B1 mit vier Sensorelementen S1 bis S4 vorgesehen werden (vgl. z.B. das Buch von E. Schrüfer: „Elektrische Meßtechnik", 6. Auflage, 1995, Carl Hanser Verlag München, Seiten 226 bis 237). Die gezeigte Brückenschaltung B1 enthält zwei Strom- oder Brückenzweige Z1 und Z2, die zwischen zwei Anschlußpunkten A1 und A2 der Brücke parallelgeschaltet sind und zwei unabhängige Halbbrücken darstellen. Über die Brücke soll an den Anschlußpunkten A1 und A2 ein Strom I geführt werden. Jeder Brückenzweig Z1 und Z2 enthält zwei in Reihe geschaltete Sensorelemente S1 und S2 bzw. S3 und S4. Zwischen den beiden Elementen jedes Brückenzweigs liegt ein Meßpunkt P1 bzw. P2 der Brücke. An diesen Meßpunkten kann eine Meßspannung U2 bzw. U3 abgenommen werden. Dabei ist bei der erfindungsgemäßen Brücke eine Brückenspannung zwischen den Meßpunkten durch eine einfache Differenzbildung der Spannungen nicht möglich. Denn jeder eine Halbbrücke darstellende Stromzweig ist selbständig zu betrachten; d.h., die Spannungen U2 und U3 sind selbständig abzugreifen. In der Figur sind ferner an den einzelnen Sensorelementen S1 und S4 die ausgerichteten Magnetisierungen $m_1$ bis $m_4$ ihres jeweiligen Biasschichtteils durch gepfeilte Linien veranschaulicht. Dabei legen z.B. die Magnetisierungen $m_1$ und $m_2$ eine Bezugslinie b der Sensoreinrichtung fest. Gemäß der Erfindung sollen in jedem Brückenzweig Z1, Z2 die beiden Sensorelemente S1, S2 bzw. S3, S4 Magnetisierungen $m_1$, $m_2$ bzw. $m_3$, $m_4$ aufweisen, die jeweils zumindest annähernd antiparallel gerichtet sind. Darüber hinaus sollen die Magnetisierungen $m_1$, $m_2$ der Biasschichtteile der Sensorelemente S1, S2 in dem ersten Brückenzweig Z1 bzw. die Bezugslinie b so verlaufen, daß sie mit durch die Magnetisierungen $m_3$, $m_4$ der Biasschichtteile der Sensorelemente S3, S4 in dem anderen Brückenzweig Z2 entsprechend festgelegten Bezugslinien einen Winkel einschließen, der ungleich null oder 180° ist. Vorteilhaft wird ein Winkel zwischen 10° und 170°, insbesondere zwischen 20° und 160°, vorzugsweise zwischen 40° und 140° gewählt. Gemäß dem Ausführungsbeispiel nach Figur 2 stehen die Magnetisierungen $m_1$, $m_3$ bzw. $m_2$ und $m_4$ jeweils zumindest annähernd senkrecht aufeinander. Dabei ist es von Vorteil, daß alle Sensorelemente der Brückenschaltung möglichst denselben Grundwiderstand $R_0(T)$ und feldempfindlichen Widerstand $\Delta R(\alpha, T)$ haben. Läßt man dann über die Brücke einen Strom I fließen, so erhält man am Anschlußpunkt A1 und den Meßpunkten P1 und P2 Spannungen U1, U2 und U3, die vom Winkel $\alpha$ des externen Magnetfeldes H gegenüber der Bezugslinie b abhängen. Gemäß dem dargestellten Ausführungsbeispiel ist der Anschlußpunkt A2 auf Nullpotential gelegt.

Aus dem Diagramm der Figur 3, in dem in Ordinatenrichtung die Spannungen U (in willkürlichen Einheiten) und in Abszissenrichtung der Winkel $\alpha$ (in Grad) dargestellt sind, ergeben sich dann die folgenden Spannungen:

$$U1 = 2[U_0(T) + \tfrac{1}{2} \Delta U(T)] \qquad (4)$$

$$U2 = U_0(T) + \tfrac{1}{2} \Delta U(T) (1 + \cos \alpha)$$

$$U3 = U_0(T) + \tfrac{1}{2} \Delta U(T) (1 + \sin \alpha)$$

$U_0$ ist eine durch einen Grundwiderstand festgelegte Spannung. Die Spannung U1 und somit der Brückenwiderstand hängt also im wesentlichen nur noch von der Temperatur der Sensoreinrichtung ab, nicht aber von dem angelegten Magnetfeld. Durch eine entsprechende Subtraktion der Spannungen U1, U2 und U3 kann man dann ein Signal erhalten, das nur noch vom feldempfindlichen Teil der Spannungen $\Delta U$ abhängt:

$$U2 - \tfrac{1}{2} U1 = \tfrac{1}{2} \Delta U(T) \cos\alpha \qquad (5)$$

$$U3 - \tfrac{1}{2} U1 = \tfrac{1}{2} \Delta U(T) \sin\alpha$$

$$2 U2 - U1 = \Delta U(T) \cos\alpha \qquad (6)$$

$$2 U3 - U1 = \Delta U(T) \sin\alpha$$

Die Differenzen, die in den Gleichungen (5) angegeben sind, erhält man z.B. mit einer Schaltung, wie sie in Figur 4 angedeutet ist. Die beiden Widerstände R' und R" dieser Schaltung sollten hochohmig sein und dienen als Spannungsteiler für die Spannung U1. Wegen herstellungsbedingter Unterschiede der Widerstände der Sensorelemente können die Widerstände R' und R" ungleich sein. Nachfolgend sei jedoch der Idealfeld angenommen, daß R' = R" ist. Dabei stellt die Raute in der Mitte der Schaltung die Brückenanordnung B1 der erfindungsgemäßen Sensoreinrichtung mit den vier Sensorelementen S1 bis S4 gemäß Figur 2 dar. Zwei Operationsverstärker der Schaltung sind mit O1 bzw. O2 bezeichnet. An ihren Ausgängen a1 bzw. a2 sind die Spannungen U2 - ½ U1 bzw. U3 - ½ U1 nach den Gleichungen (5) abzunehmen. Kurven dieser Spannungssignale sind in dem Diagramm der Figur 5 wiedergegeben, wobei in Ordinatenrichtung die Spannung U (in willkürlichen Einheiten) und Abszissenrichtung der Winkel $\alpha$ (in Grad) aufgetragen sind. Wie aus dem Diagramm zu entnehmen ist, erhält man also zwei cosinus- bzw. sinusartige Spannungssignale mit einer Amplitude von $\pm \tfrac{1}{2} \Delta U$. Dieser Wert entspricht der Hälfte des Spannungssignals einer üblichen Standardbrücke.

Die Spannungsdifferenzen, wie sie aus den Gleichungen (6) hervorgehen, erhält man z.B. mit einer Schaltung, wie sie in Figur 6 angedeutet ist. Gegenüber der Ausführungsform nach Figur 4 sind hierbei noch zwei weitere Paare von Operationsverstärkern O3, O4 bzw. O5, O6 erforderlich. Dabei liegt am nicht-invertierten Eingang des Operationsverstärkers O1 die Spannungsdifferenz U1 - U2 an, während sich der nicht-invertierte Eingang des Operationsverstärkers O2 auf der Spannungsdifferenz U1 - U3 befindet. An den Ausgängen a1 und a2 des Operationsverstärkers O1 bzw. O2 sind dann die Spannungsdifferenzen 2 U2 - U1 bzw. 2 U3 - U1 abzugreifen. Die entsprechenden Spannungssignale sind in dem Diagramm der Figur 7 wiedergegeben, wobei eine Figur 5 entsprechende Darstellung gewählt ist. Aus diesem Diagramm geht hervor, daß man zwei cosinus- bzw. sinusartige Spannungssignale mit einer Amplitude von $\pm \Delta U$ erhält. Dieser Wert entspricht dem Spannungssignal der vorerwähnten Standardbrücke.

Die Signale gemäß den Gleichungen (5) und (6) werden dann in an sich bekannter Weise mittels einer geeigneten Schaltung temperaturkompensiert und weiterverarbeitet, z.B., um die Richtung des externen Magnetfeldes H zu bestimmen, wie es für ein kontaktloses Potentiometer erforderlich ist.

Gemäß dem in Figur 2 dargestellten Ausführungsbeispiel einer Brückenanordnung B1 einer erfindungsgemäßen Sensoreinrichtung wurde davon ausgegangen, daß die Magnetisierungen $m_3$ und $m_4$ der Biasschichtteile der Sensorelemente S3 und S4 zumindest annähernd senkrecht zu der durch die Richtungen der Magnetisierungen $m_1$ und $m_2$ der Biasschichtteile der anderen Sensorelemente S1 und S2 festgelegten Bezugslinie b ausgerichtet sind. Es ist jedoch auch möglich, daß z.B. die Richtungen der Magnetisierungen $m_3$ und $m_4$ mit der Bezugslinie b einen beliebigen Winkel ($\neq 0°$ oder $\neq 180°$) einschließen. Vorteilhaft sollte der Winkel zwischen 10° und 170°, insbesondere zwischen 20° und 160°, vorzugsweise zwischen 40° und 140° liegen. Figur 8 zeigt ein entsprechendes Ausführungsbeispiel einer Brückenanordnung B2 in einer Figur 2 entsprechenden Darstellung. Die Brückenanordnung B2 enthält vier Sensorelemente S1, S2, S3' (mit einer Biasmagnetisierung $m_3'$) und S4' (mit einer Biasmagnetisierung $m_4'$). Die Biasmagnetisierungen $m_3'$ und $m_4'$, d.h. durch sie festgelegte Bezugslinien, schließen dabei mit der wiederum durch die Magnetisierungen $m_1$ und $m_2$ festgelegten Bezugslinie b einen Winkel $\beta$ von 45° ein. Dann ergeben sich in Analogie zu Figur 2 die folgenden Signale:

$$U2 - \tfrac{1}{2} U1 = \tfrac{1}{2} \Delta U(T) \cos\alpha \qquad (7)$$

$$U3 - \tfrac{1}{2} U1 = \tfrac{1}{2} \Delta U(T) \cos(\alpha - \beta)$$

Diese Brückenanordnung B2 kann insbesondere dazu dienen, die Auflösung eines kontaktlosen Potentiometers in einem bestimmten Winkelbereich zu verbessern, da die linearen Bereichen der cosinusartigen Signale besser ausgenutzt werden können.

In Abweichung von den dargestellten Ausführungsbeispielen der Brückenanordnungen B1 und B2 ist es selbstverständlich auch möglich, deren einzelne Sensorelemente durch mehrere parallel- oder hintereinandergeschaltete Elemente zu ersetzen.

Darüber hinaus können erfindungsgemäße Sensoreinrichtungen auch eine Serien- oder Parallelschaltung aus mindestens zwei Brückenanordnungen B1 und/oder B2 aufweisen. Hierbei ist es auch möglich, daß die Bezugsrichtungen der einzelnen Brückenanordnungen miteinander einen vorbestimmten Winkel einschließen, der z.B. 45° oder 90° beträgt.

Die Brückenanordnungen von Sensorelementen stellen auch nur einen Spezialfall bei erfindungsgemäßen Sensoreinrichtungen dar. Für eine Trennung des Signals in einen rein temperaturabhängigen Signalanteil und einen temperatur- und feldabhängigen Signalanteil sind nämlich nur ein Paar von Sensorelementen für den rein temperaturabhängigen Signalanteil und ein einzelnes Sensorelement für den temperatur- und feldabhängigen Signalanteil erforderlich. Figur 9 zeigt eine erste Ausführungsform einer Pseudobrückenanordnung B3 mit einem Sensorelementpaar S1, S2, deren Biasmagnetisierungsrichtungen antiparallel verlaufen und eine Bezugslinie b festlegen, sowie mit einem einzelnen Sensorelement S3, dessen Biasmagnetisierungsrichtung senkrecht zur Bezugslinie b verläuft. Das Paar der Sensorelemente S1, S2 ist wiederum in Serie geschaltet und wird von einem Strom I1 durchflossen. Parallel dazu liegt das Sensorelement S3, das von einem Strom I2 einer getrennten Stromversorgung durchflossen wird. Die beiden die Ströme I1 und I2 fuhrenden Stromzweige Z1 und Z2" sind gemäß dem dargestellten Ausführungsbeispiel parallel angeordnet und gemeinsam an einem Ende auf Nullpotential gelegt. Unter der Voraussetzung, daß die beiden Ströme I1 und I2 gleich groß sind, ergibt sich eine Auswertung analog wie bei der Brückenschaltung B1; hier besteht jedoch der Vorteil einer vergleichsweise geringeren Anzahl von Sensorelementen. Für die Signale gelten hier somit die Gleichungen (5).

Die in Figur 10 gezeigte weitere Ausführungsform einer Pseudobrückenanordnung B4 von 3 Sensorelementen S1, S2 und S3' unterscheidet sich von der Anordnung B3 nach Figur 9 nur dadurch, daß ihr einzelnes Sensorelemente S3' mit der Bezugslinie b des Sensorelementpaares S1, S2 einen beliebigen Winkel β von beispielsweise 45° einschließt (wie gemäß Figur 8). Auch hier kann man, wie selbstverständlich auch bei der Ausführungsform nach Figur 9, viele zusätzliche Einzelsensorelemente parallelschalten mit beliebigen Biasmagnetisierungsrichtungen, aber stets mit eigenen Stromversorgungen. Für die Signale der Pseudobrückenanordnung B4 ergeben sich dann in Analogie zu der Brückenanordnung B2 nach Figur 8 die Gleichungen (7).

Wie mit Figur 11 verdeutlicht sein soll, brauchen zum Aufbau einer erfindungsgemäßen Sensoreinrichtung mit 360°-Erfassung die beiden Stromzweige Z1 und Z2" ihrer Pseudobrückenanordnung B5 nicht unbedingt entsprechend Figur 9 an einer Seite quasi parallelgeschaltet zu sein. Vielmehr ist es auch möglich, daß die drei Sensorelemente S1, S2 und S3 elektrisch hintereinander (in Serie) geschaltet werden. In diesem Falle sind den Sensorelementen S1 und S2 mit ihren antiparallel ausgerichteten, die Bezugslinie b festlegenden Magnetisierungen $m_1$ und $m_2$ der erste Stromzweig Z1 und dem dritten Sensorelement S3 mit seiner gegenüber der Bezugslinie b z.B. unter einem rechten Winkel ausgerichteten Magnetisierung $m_3$ der zweite Brückenzweig Z2" zuzuordnen. In der Figur sind ferner die an den Ausgängen von drei Operationsverstärkern O7 bis O9 abzugreifenden Spannungen U1 bis U3 veranschaulicht. Dabei sind die beiden Eingänge des Operationsverstärkers O7 an die Hintereinanderschaltung der beiden Sensorelemente S1 und S2 angeschlossen, wahrend die Eingänge der Operationsverstärker O8 und O9 über dem einzelnen Sensor S2 bzw. S3 liegen.

## Patentansprüche

1. Sensoreinrichtung zur Erfassung eines äußeren Magnetfeldes mit mehreren magnetoresistiven Sensorelementen, die jeweils einen Dünnschichtaufbau aufweisen, der eine weichmagnetische Meßschicht und einen magnetisch härteren Biasschichtteil mit einer vorbestimmten Magnetisierungsrichtung enthält und einen großen magnetoresistiven Effekt (GMR) zeigt, **gekennzeichnet** durch

   - mindestens ein Paar von Sensorelementen (S1, S2) mit Magnetisierungen ($m_1$, $m_2$) ihrer Biasschichtteile, die zumindest im wesentlichen zueinander antiparallel ausgerichtet sind und eine Bezugslinie (b) festlegen, und
   - mindestens ein weiteres Sensorelement (S3, S3', S4, S4') mit einer Magnetisierung ($m_3$, $m_3'$, $m_4$, $m_4'$) seines Biasschichtteils, die mit der Bezugslinie (b) einen vorbestimmten Winkel (β) einschließt.

2. Einrichtung nach Anspruch 1, **dadurch gekennzeichnet,** daß der Winkel (β) zwischen der Magnetisierungsrichtung des mindestens einen weiteren Sensorelementes (S3, S3', S4) und der Bezugslinie (b) zwischen 10 und 170 Grad, vorzugsweise zwischen 20 und 160 Grad liegt.

3. Einrichtung nach Anspruch 2, **dadurch gekennzeichnet,** daß die Magnetisierung ($m_3$, $m_4$) des Biasschichtteils des wenigstens einen weiteren Sensorelementes (S3, S4) zumindest annähernd senkrecht zu der Bezugslinie (b) verläuft.

4. Einrichtung nach Anspruch 2, **dadurch gekenn-**

**zeichnet,** daß die Richtung der Magnetisierung ($m_3'$, $m_4'$) des Biasschichtteils des wenigstens einen weiteren Sensorelementes (S3', S4') und die Bezugsrichtung (b) einen Winkel ($\beta$) von wenigstens annähernd 45° einschließen.

5. Einrichtung nach einem der Ansprüche 1 bis 4, **dadurch gekennzeichnet,** daß das mindestens eine Paar der Sensorelemente (S1, S2) in einem ersten Stromzweig (Z1) und das wenigstens eine weitere Sensorelement (S3, S3', S4, S4') in einem zweiten Stromzweig (Z2, Z2',Z2") angeordnet sind.

6. Einrichtung nach Anspruch 5, **dadurch gekennzeichnet,** daß der erste Stromzweig (Z1) mit zwei Sensorelementen (S1, S2) und der zweite Stromzweig (Z2') mit einem weiteren Sensorelement (S3, S3') jeweils von einem konstanten Strom (I1 bzw. I2) durchflossen sind.

7. Einrichtung nach Anspruch 6, **dadurch gekennzeichnet,** daß die beiden Stromzweige (Z1, Z2") an einer Seite elektrisch zusammengeschaltet sind.

8. Einrichtung nach Anspruch 7, **gekennzeichnet** durch eine Serienanordnung der Stromzweige (Z1, Z2").

9. Einrichtung nach Anspruch 5, **dadurch gekennzeichnet,** daß die beiden Stromzweige (Z1; Z2, Z2') Brückenzweige einer Brückenanordnung (B1, B2) von mindestens vier Sensorelementen (S1, S2, S3, S3', S4, S4') sind.

10. Einrichtung nach Anspruch 9, **dadurch gekennzeichnet,** daß in jedem Stromzweig (Z1, Z2, Z2') die Sensorelemente (S1, S2 bzw. S3, S4; S3', S4') zumindest weitgehend zueinander antiparallel ausgerichtete Magnetisierungen ($m_1$, $m_2$ bzw. $m_3$, $m_4$; $m_3'$, $m_4'$) aufweisen.

11. Einrichtung nach einem der Ansprüche 1 bis 10, **dadurch gekennzeichnet,** daß alle Sensorelemente (S1, S2, S3, S3', S4, S4') einen Schichtaufbau aufweisen, dessen Widerstand sich zumindest annähernd aus einem ersten Widerstandsanteil (Grundwiderstand) und einem zweiten Widerstandsanteil, der eine Abhängigkeit von dem äußeren Magnetfeld zeigt, zerlegen läßt, und daß alle Sensorelemente wenigstens annähernd denselben ersten Widerstandsanteil und denselben zweiten Widerstandsanteil besitzen.

12. Einrichtung nach Anspruch 11, **gekennzeichnet** durch Sensorelement (S1, S2, S3, S3', S4, S4') mit gleichem Schichtaufbau und gleicher Geometrie.

FIG 1

8

FIG 2

**FIG 3**

FIG 4

**FIG 5**

FIG 6

EP 0 807 827 A2

**FIG 7**

**FIG 8**

**FIG 9**

FIG 10

**FIG 11**